## Europäisches Patentamt
## European Patent Office
## Office européen des brevets

(11) Publication number: **0 167 033**
**B1**

# EUROPEAN PATENT SPECIFICATION

(45) Date of publication of patent specification: **20.09.89**

(21) Application number: **85107251.2**

(22) Date of filing: **14.06.85**

(51) Int. Cl.⁴: **H 01 L 23/40, H 01 L 23/36**

(54) Apparatus for conduction cooling.

(30) Priority: **29.06.84 US 626554**

(43) Date of publication of application:
**08.01.86 Bulletin 86/02**

(45) Publication of the grant of the patent:
**20.09.89 Bulletin 89/38**

(84) Designated Contracting States:
**DE FR GB**

(56) References cited:
**WO-A-83/02363**
**US-A-3 972 012**
**US-A-3 993 123**

**IBM TECHNICAL DISCLOSURE BULLETIN, vol.
26, no. 7B, December 1983, pages 3623-3624,
New York, US; F.J. AICHELMANN et al.:
"Thermally enhanced integrated circuit chip
module"**

(73) Proprietor: **International Business Machines
Corporation
Old Orchard Road
Armonk, N.Y. 10504 (US)**

(72) Inventor: **Ostergren, Carl David
Rd. No. 3, Box 636
Montgomery New York 12549 (US)**
Inventor: **Paivanas, John Angelo
Deceased (US)**

(74) Representative: **Gaugel, Heinz, Dipl.-Ing.
Schönaicher Strasse 220
D-7030 Böblingen (DE)**

Courier Press, Leamington Spa, England.

## Description

This invention relates to conduction cooling of small heat generating electronic devices such as integrated circuit (IC) chips, and more particularly, to a cooling device having an extremely low thermal resistance path between the IC chip and the heat sink.

As used herein, thermal resistance R is defined as $R=\Delta T/Q$, where $\Delta T$ is the temperature difference and Q is the heat flow between two sections in space. This relationship is a consequence of Fourier's conduction equation $Q=kA(\Delta T/L)$, where A is the cross-sectional area normal to the heat flow, L is the distance through which the heat flows, and k is the thermal conductivity of the medium.

The introduction of large scale integration (LSI) and very large scale integration (VLSI) at the chip level and large scale integration at the module level by packaging multiple chips on a single multilayer ceramic (MLC) substrate has significantly increased the number of circuits per unit volume, and at the same time increased their heat flux density. For example, integration at the chip and module levels has resulted in circuit densities as high as $2.5\times10^7$ circuits per cubic meter with the necessity of removing heat flux densities on the order of 1000 $kW/m^2$ at the chip level. To remove these high heat flux densities various means of dissipating the heat have been investigated. Of these the gas encapsulated conduction-cooling technique as embodied in the thermal conduction module (TCM) and disclosed in U.S. Patent No. 3,993,123, issued to Chu et al and assigned to IBM Corporation, the present assignee, and in the articles entitled "Thermal Conduction Module: A High Performance Multilayer Ceramic Package", by A. J. Blodgett and D. R. Barbour and "Conduction Cooling for an LSI Package: A One Dimensional Approach" by R. C. Chu, U. P. Hwang and R. E. Simons and published in IBM Journal of Research and Development, Vol. 16, No. 1, January 1982, at pages 30—36 and 45—54, respectively, has proven to be the most advantageous technique hitherto.

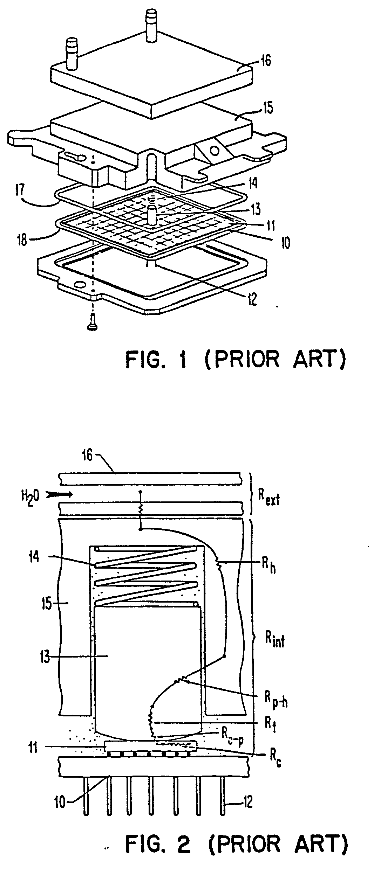

The components of this prior art TCM assembly are shown schematically in Fig. 1 wherein 10 designates a MLC substrate. In one example the substrate 10 is 90×90 mm in area, contains up to 33 layers and is capable of providing power dissipation and wiring for, typically, up to 100 logic chips 11 or a combination of 118 logic or array chips. The substrate 10 has typically about 1800 I/O pins 12 brazed on the bottom surface thereof for purposes of connecting to the next level package. A cylindrical piston 13, one for each chip 11 on the substrate 10, is biased by means of a spring 14 so as to contact the back of each chip, provides the main heat conductive path to a water cooled housing consisting of a cover or hat 15 and a cold plate 16, the latter having suitable chambers for circulation of water. A metal C-ring 17 coated with wax and compressed between the hat 15 and the substrate frame 18 forms a reworkable hermetic seal. Helium gas at a pressure of about 1.6 atm. is provided in the interface gaps of the sealed module to serve as a heat-conducting medium and enhance conduction of heat from the chip to the hat. The face of the piston 13 that directly contacts the chip 11 is machined to a 150 mm spherical radius to minimize off-center contact due to chip tilt and thereby provide uniform chip temperatures and reduced mechanical stress on the chip.

For convenience in analyzing the thermal performance of the TCM, reference is made to Fig. 2 which illustrates in a cross-sectional representation a single-chip unit of the TCM and the thermal resistance of the heat path from the chip 11 to the cold plate 16 divided into various segments. $R_{ext}$ designates the external thermal resistance and is defined relative to the module as

$$R_{ext}=\frac{\Delta T_{h-iw}}{P_m}$$

where $\Delta T_{h-iw}$ is the temperature difference between the hat 15 and the inlet wafer and $P_m$ is the module power. $R_{ext}$ is divided into two parts: the interfacial resistance between the hat 15 and the mating surfaces of the cold-plate 16 and the resistance between the cold-plate surface and the circulating wafer inside the cold plate. $R_{int}$ designates the internal thermal resistance of the TCM and is defined as

$$R_{int}=\frac{\Delta T_{c-h}}{P_c}$$

where $\Delta T_{c-h}$ is the temperature difference between the chip 11 and the top of the hat 15 and $P_c$ is the chip power. $R_{int}$ is composed of five component resistances. $R_c$, $R_{c-p}$, $R_t$, $R_{p-h}$ and $R_h$. $R_c$ designates the chip internal resistance, $R_{c-p}$ is the thermal resistance in the interface between the chip 11 and the piston 13, $R_t$ is the thermal resistance of the piston 13, $R_{p-h}$ is the thermal resistance between the piston 13 and the hat 15 and $R_h$ designates the thermal resistance of the hat 15.

The thermal resistance in the interface between the chip 11 and the piston 13, $R_{c-p}$, is a complex function of many geometric, physical and thermal characteristics of the contacting solids and the interfacial helium gas medium. $R_{c-p}$ is composed of three parallel thermal resistances; a conduction resistance through many small metallic contact areas, thermal radiation resistance through the gap, and thermal conduction resistance through the interfacial helium gas medium. The last of these three resistances being the lowest, the most dominant thermal conduction path is the thermal conduction across the interfacial helium gas.

The thermal resistance $R_{p-h}$ between the piston 13 and the hat 15 is a function of several parameters including the radius and the length of the piston 13, the annular gap between the piston 13 and the hat 15, the cross-sectional areas of the hat 15, the temperatures and thermal conductivities of the piston and hat.

As disclosed in the aforementioned Chu et al article, typical values of the various thermal resistances discussed above are as follows: $R_c=0.43°C/W$, $R_{c-p}=2.9°C/W$, $R_t=1.02°C/W$, $R_{p-h}=2.15°C/W$ and $R_h=1.58°C/W$ adding up to a module total internal resistance $R_{int}$ of 8.08°C/W. $R_{ext}$ is typically about 0.15°C/W.

Despite these impressively low thermal resistances, the prior art TCM has inherent limitations, due to the particular shapes and sizes of the heat conducting elements, e.g., the piston and the hat assembly, in its ability to transfer heat from the IC chip to the cold plate so as to maintain the chip temperature in the required range between 40°C and 85°C particularly in the case of presently contemplated VLSI chips having a power dissipation of 50 watts or higher. Another disadvantage of the above prior art TCM is the critical requirement imposed by the thermal design thereof of using helium gas in the interface between the chip and the piston, and in the annulus between the piston and the hat at a sufficient level. Although helium possesses excellent thermal properties for a gas and is inert, nontoxic, and nonflammable, it is extremely difficult to contain in a sealed enclosure. In addition, under molecular flow conditions, air will enter the enclosure at the same time helium is leaking out, thereby rendering the high product performance of the TCM dependent upon its time-dependent sealing characteristics.

The invention as claimed is intended to remedy these drawbacks. It solves the problem of how to design a TCM for cooling high power dissipating IC chips without utilizing helium gas environment in the interface gaps therein, and how to design a TCM having an extremely low thermal resistance path from the IC chip to the outer hat surface region.

It is still another object of the invention to provide a TCM in which the chip to conductive surface contact interface is maintained at a low thermal resistance regardless of the chip tilt.

It is another object of the invention to provide a simple inexpensive structure between the IC chip and the hat which not only insures the most advantageous contact with the chip and hat surfaces, but also is mechanically flexible.

In one illustrated preferred embodiment of the invention the thermal conduction disc is a heat conductive flat based, truncated solid conical piece which is spring loaded on the IC chip to be cooled by contacting the flat base with the back of the chip. The hat also is heat-conductive, the bottom portion thereof being provided with a tapered opening for conformally receiving the thermal conduction disc. The gap between the tapered surfaces of the hat and the disc which embrace each other is filled with a conductive thermal grease for providing not only a low interfacial thermal resistance between the disc and the hat, but also serving as an effective damping medium against impact loads on the chip. A heat sink thermally coupled to the hat removes the heat transferred to the hat by the IC chip via the disc.

For additional enhancement of chip cooling, a thin conformal layer of a self-healing, highly thermal conductive and low melting point alloy, which upon melting provides a low interfacial thermal resistance, is provided between the chip and the base of the disc.

The invention will be best understood by reference to the detailed description which follows in conjunction with the accompanying drawings, wherein:

Fig. 1 is an exploded perspective view of a conventional thermal conduction module.

Fig. 2 is a fragmentary illustration in a cross-sectional representation of a part of the conventional thermal conduction module showing the various thermal resistances in the thermal path between the IC chip and the heat sink.

Fig. 3 is a fragmentary portion in cross-sectional representation of an embodiment of a thermal conduction module incorporated therein a thermal conduction disc in accordance with the present invention showing the novel features.

Fig. 4 is a geometrical construction of a fragment of the tapered surfaces of the thermal conduction disc and the overlying hat of the thermal conduction module of the present invention illustrating the geometrical relationship between the thickness of the grease interface between these surfaces, the vertical travel of the hat with respect to the disc and the degree of taper of the tapered surfaces.

Figs. 5 and 6 are schematic cross-sectional views of the portion of the module of Fig. 3 at different stages of assembly of the module.

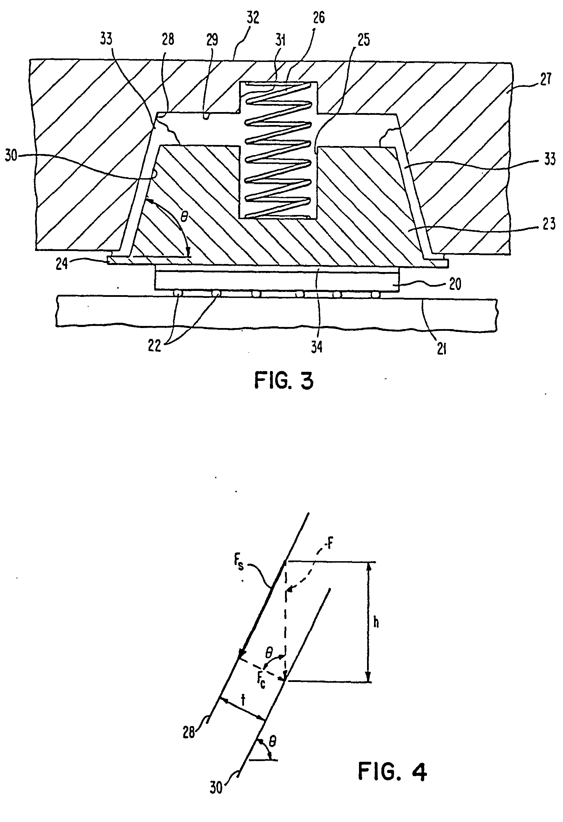

The specific essential elements of a thermal conduction module in accordance with the present invention are illustrated in Fig. 3. In Fig. 3 the IC chip that is desired to be maintained in a specific temperature range by rapidly dissipating away heat therefrom is designated by numeral 20. Chip 20 is mounted on a multilayer ceramic substrate 21 via solder ball connections 22 in a face-down orientation. That is, the chip surface containing the integrated circuits is mounted face-down to the substrate 21. A heat conductive disc 23 (also referred to herein as thermal conduction disc) shaped in the form of a truncated solid cone and having a flat base is mounted on the chip 20 such that the flat base contacts the back surface of chip 20. The back surface of the IC chip 20 is typically flat within about 1 microinch. The base of disc 23 is also machined to an extraordinarily high degree of flatness matching that of the chip thereby minimizing, upon assembly, any gap between the two contacting surfaces under consideration. The smaller the gap between the chip surface and the base of the disc 23, the smaller the thermal resistance therebetween. The surface area of the base 23 is tailored to be generally larger than the surface area of the chip 20 to permit the base of disc 23 to maintain continuous contact with chip 20 even when the latter tilts due to imperfect solder ball mountings 22.

The base portion of the disc 23 is provided with a lip 24 which extends beyond the slanted wall of the disc 23.

Located in the top portion of the disc 23 is a spring retainer opening 25 to accommodate therein a compression spring 26. The spring 26 provides a force to the thermal conduction disc 23 which presses against the chip 20 making a good heat conductive contact therewith.

Overlying the conical truncated disc 23 in a conformal or mating relationship therewith is a heat conductive hat member 27 having an opening with a continuous tapered sidewall 28 and essentially flat ceiling 29. The angle of taper of the sidewall 28 closely matches the tapering angle $\theta$ corresponding to the tapered surface 30 of the disc 23 indicated in Fig. 3. The ceiling 29 contains a circular slot 31 to retain the upper portion of the compression spring 26. The hat member 27 has an upper surface 32 for attaching to a heat sink in the form of a water cooled cold plate. Alternatively, the hat 27 may be provided with large fins extending therefrom over which cold air is blown to dissipate heat from the hat.

In the gap between the tapered surfaces 28 and 30 of the hat 27 and the disc 23, respectively, which has a finite dimension t is provided a highly thermal conductive grease 33 having a low thermal resistance in the range of 1—1.2°C/watt per mil of thickness (for a chip area of 4.5×4.5 mm$^2$) and a rheology such that it will fill the narrow gap to form a dense pack and ensure good thermal contact between the disc 23 and the hat 27.

There are several factors that enure from the conformal tapered surfaces 28 and 30 of the hat 27 and disc 23 assembly shown in Fig. 3. First, the surface area of contact between the disc 23 and hat 27 is maximized. Typically, the tapered surface area of contact is about 5—10 times the area of the chip 20. Such a maximized area of contact between the disc 23 and hat 27 maximizes the removal of heat flux from the disc to the hat. Another advantageous aspect of the tapered arrangement is that it provides the most favorable chip loading and mechanical flexibility conditions. To elaborate on this, referring to Figs. 3 and 4, the vertical travel of the hat 27 with respect to the disc 23 designated by the letter h is related to the thickness t of the grease in the gap between surfaces 28 and 30 by the trigonometric equation h=t Sec $\theta$. Since the taper angle $\theta$ is large, typically close to 90°, the disc 23 can move within the hat 27 a large vertical distance h for small variations in the grease thickness t thereby providing mechanical flexibility. Regarding the favorable chip loading aspect, referring again to Figs. 3 and 4, when the hat 27 provides a normally directed load F (which is the compression force in the spring 26) this load is applied on the disc 23 as two components: a compression force $F_c$ which is

related to F by $F_c$=F Cos $\theta$ and a shear force $F_s$ which is given by $F_s$=F Sin $\theta$. Since the taper angle $\theta$ is typically close to 90°, the load F is conveyed to the disc 23 predominantly as the shear force $F_s$, nevertheless a finite compression force $F_c$ is applied on the disc thereby assuring a good thermal contact between the disc 23 and hat 27.

The preferred range of the taper angle $\theta$ is 85°C$\leq\theta\leq$90°C. When $\theta$ is less than 85°C, the compression force $F_c$ will be rather too high requiring a rather thick grease layer between surfaces 28 and 30. Such a thick layer of grease will render the thermal path between hat 27 and disc 23 ineffective. When $\theta$=90°, all the force applied by the hat 27 on the disc 23 will be shear force without any compressive force thereby rendering the thermal contact between the two mating elements 23 and 27 rather poor.

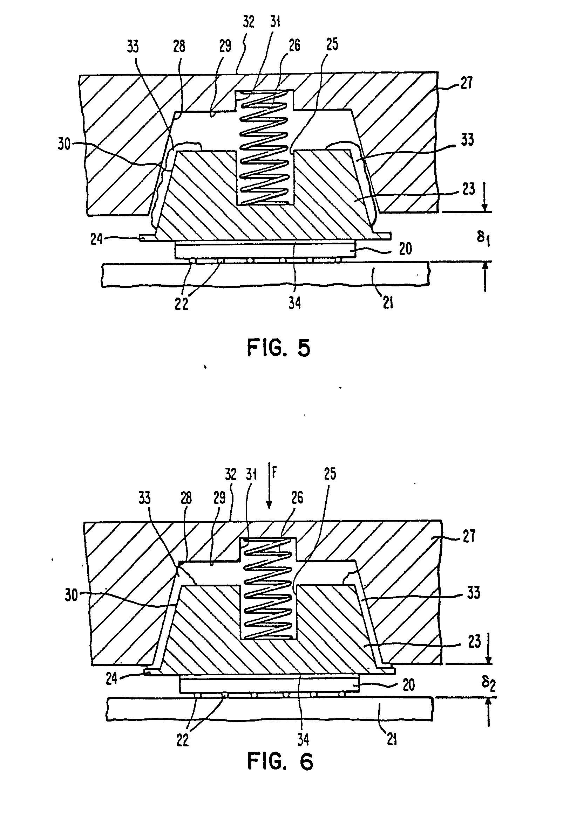

The basic assembly features of the thermal conduction disc 23 and the conformal hat 27 are illustrated in Figs. 5 and 6 which show the initial and final assembly features, respectively. In the initial condition, represented by a large separation $\delta_1$ between the substrate 21 and the hat 27 and a large and nonuniform grease 33 thickness, the disc 23 is free to swivel and seat fully on the chip 20. Upon assembly, which is represented by a smaller separation $\delta_2$ between the substrate 21 and the hat 27, at a given contact load F the grease 33 thickness is reduced by the mutually opposite shear forces applied by surfaces 28 and 30 on the grease 33 therebetween while maintaining the initial seating condition. The grease flow resulting during the assembly can be controlled to move into the hat region, i.e. in the region between the ceiling 29 of hat 27 and the top truncated surface of the disc 23, rather than down into the chip region by taking advantage of the higher extrusion resistance offered by the tapered hat surface 28 as the disc 23 pushes into the hat 27. Further, any grease that flows downward during the assembly conveniently remains on the protruding lip 24 at the base of the disc 23 rather than reach the chip region. Typically, about 100—150 grams contact load, applied via the spring 26 compression, is sufficient to provide the necessary thermal contact.

Typical materials that can be used to fabricate the disc 23 and the overlying hat 27 include aluminum, copper, silver and silicon carbide. Due to its large mass density and high thermal conductivity, copper is particularly suitable for forming the disc 23.

The dimensions of the thermal conduction disc 23 are determined by the size and power dissipation of the chip to be cooled. For example, in order to efficiently dissipate heat from a 30 watt chip of chip size 4.5×4.5 mm$^2$, a copper disc 23 of height about 0.75 cm and mean diameter of the conical portion of the disc of about 0.65 cm, resulting in a surface area of the conical portion of 1.5 cm$^2$ is essential.

By utilizing the thermal conduction disc 23 and hat 27 combination having a thermal grease interface therebetween shown in Figs. 3, 5 and 6, the thermal resistance between the chip and the top of the hat, $R_{int}$, can be decreased by a factor of approximately three compared to the prior art gas encapsulated construction utilizing a cylindrical piston having a curved bottom and a hat having a straight-walled opening to enclose the piston.

Further enhancement of the heat transfer from the chip to the heat sink can be achieved by the invention by further reducing the thermal resistance between the chip 29 and the disc 23 by providing a conformal interface layer of a self-healing alloy material 34 having a high thermal conductivity and low melting point, as illustrated in Figs. 3, 5 and 6, between the back surface of chip 20 and the base of disc 23. The alloy material has a low solidus temperature in the range 85—90°C and a low liquidus temperature in the range 110—115°C and provides a self-healing interface between the chip 20 and disc 23 upon disruption of this interface. An example of a suitable alloy material 34 is the commercially available Ostalloy produced by Acronium, Inc., Providence, Rhode Island, which consists of bismuth (46.7%), lead (39.3%), tin (12.4%) and indium (16%). Ostalloy has a solidus temperature of 88°C and a liquidus temperature of 110°C. A 25 micron (1 mil) thick coating of Ostalloy that is metallurgically bonded to a copper disc has a thermal resistance of less than 0.1°C/W. The Ostalloy may be applied to the base of disc 23 by simple soldering or by arc-spraying.

The interface alloy layer 34 enhances the cooling ability of the disclosed structure by eliminating any voids that may exist between the two contacting chip 20 and disc 23 surfaces which introduce high thermal resistance paths therebetween due to the disruption created by the void. The presence of the alloy layer 34 prevents this since if the interface is disrupted there will be an increase in its thermal resistance and a rise in chip temperature. If the rise in chip temperature is great enough to raise the alloy 34 temperature above its solidus temperature, the alloy will reflow and establish a conformal interface and the chip temperature will return to the normal range.

Thermal experiments conducted on a model of the device shown in Figs. 3—6, utilizing the Ostalloy interface between the chip 20 and thermal conduction disc 23 and a thermal grease interface between the disc 23 and the hat 27 demonstrated that by using the subject device the thermal resistance $R_{int}$ can be reduced by a factor 6 compared to the prior art gas encapsulated device.

In summary, the truncated solid conical disc and the tapered hat fitting conformally over the disc with the gap therebetween being densely packed with a thin layer of a high thermal conductive grease provides a simple, efficient and excellent thermal conduction means to transfer heat from a high wattage IC chip to a cold sink. This excellence in heat transfer is due to the enormously large surface area of contact between the disc and the hat stemming from the unique shapes of these elements. The efficiency in heat transfer is due to the provision of the grease interface between these large surfaces. Further improvement in heat transfer arises from the unique low melting point and high thermal conductivity alloy interface provided between the IC chip and the base of the disc.

While the invention has been discussed by focussing on a single disc-hat combination to cool a single chip it is easily extendable to cool a multiple number of chip by constructing a TCM utilizing the invention. Such a TCM easily meets the application requirements imposed on it by use of large-scale system processors which include temperature, humidity, power on/off, machine lifetime, failure rate, and various mechanical requirements. The TCM so designed, in addition to providing an efficient cooling path, ensures adequate mechanical and environmental protection of the IC chips.

Thus, there has been provided in accordance with the invention, an improved single or multiple chip thermal cooling apparatus that fully satisfies the objects and advantages set forth above.

While the invention has been described in conjunction with a specific preferred embodiment, it is evident that many alternatives, modifications and variations will be apparent to those skilled in the art in light of the foregoing description. For example, the thermal conduction disc can have a thimble shape with the inner lateral area addressing a protrusion from the hat. This would result in a much greater hat-grease interface area with attendant lower thermal resistance.

## Claims

1. An apparatus for conduction cooling of a heat generating element (20), said apparatus having
   a thermally conductive truncated solid conical member (23) having a flat base in thermal communication with said element (20) via said base;
   a thermally conductive cap member (27) having a flat top portion and a bottom portion having a cavity with a flat ceiling and a continuous tapered wall (28) to mate substantially with said truncated conical member (23);
   means (26) interposed between said ceiling and said conical member (23) therebeneath for resiliently pressing said conical member (23) against said element (20);
   a thermally conductive grease layer (33) interposed between said conical member (23) and the tapered wall of said cavity; and
   heat sink means associated with said flat top portion of the cap member (27).

2. The apparatus as claimed in claim 1, wherein a self-healing alloy layer (34) is provided between said element (20) and flat base, the alloy having a low melting point and high thermal conductivity, to enhance transfer of heat from said element (20) to said conical member (23).

3. An apparatus as claimed in claim 1 or 2 wherein said element is a heat generating semiconductor integrated circuit chip (20);

the conical member is a heat conductive flat-based and truncated solid conical disc (23), said base contacting the back surface of said chip (20);

the cap member is a heat conductive, thick-walled hat (27) having a tapered inner surface (28) essentially conforming to said truncated disc (23);

the means for resiliently pressing the conical member is a spring member (26) located between said hat (27) and said disc (23) for forcing the disc (23) against the chip (20) and forming a narrow peripheral gap between the conical portion of said disc (23) and said tapered surface of the hat (27);

the conductive thermal grease layer (33) being filled in said peripheral gap for providing a low interfacial thermal resistance between the disc (23) and the hat (27).

4. The apparatus as claimed in claim 3 wherein the conical portion of the disc (23) has a surface area about 5 to 10 times the area of said chip (20).

5. The apparatus as claimed in claims 1 to 4, wherein a cavity (25) is provided in a central portion of the truncated end of said disc for retaining therein the lower portion of said spring member (26).

6. The apparatus as claimed in claim 3, wherein said hat (27) has a flat ceiling (29) with a central cavity (31) in correspondence with the cavity (25) in said disc (23) for retaining therein the upper portion of said spring member (26).

7. A module for cooling a plurality of heat generating semiconductor integrated circuit chips (20) mounted face-down to a substrate (21), said module having

a plurality of heat conductive, truncated solid conical discs (23) having a flat base, each in thermal contact with one of said chips (20) via said base;

a heat conductive module cap member sealed at the edges thereof to said substrate (21) enclosing said plurality of chips (20), said cap member having therein a plurality of cavities, each in correspondence with one of said discs (23), said cavities each having a flat ceiling (29) and a continuous outwardly tapered wall (28) to mate with said corresponding disc (23);

a plurality of springs (26) one compressed between each of said cavity ceilings (29) and said corresponding truncated disc (23) to maintain said discs pressed against respective chips (20) and also establish small peripheral gaps between the tapered wall of said cavities and the corresponding discs;

a thermal conductive grease (33) filled in said peripheral gaps; and

heat removal means thermally coupled to said module cap member for externally removing the heat generated by said chips (20) from said cap member.

8. The cooling module as claimed in claim 7, characterized by a self-healing alloy interface (34) formed between each of said chips (20) and the corresponding disc base (23), said alloy having a high thermal conductivity and low melting point, due to heat from said corresponding disc, being capable of melting and providing a low interfacial thermal resistance between said chip (20) and disc (23).

9. The cooling module as recited in claim 7 wherein said discs (23) are fabricated from a material selected from the group consisting of aluminum, copper, silver and silicon carbide.

10. The cooling module as recited in claim 7 wherein said module cap is fabricated from a material selected from the group consisting of aluminum, copper, silver and silicon carbide.

**Patentansprüche**

1. Wärmeableitungsvorrichtung für ein wärmeerzeugendes Element (20) mit

einem wärmeleitenden, abgestumpften, massiven, konischen Teil (23) mit ebener Grundfläche, das über letztere wärmeleitend mit dem genannten Element (20) verbunden ist;

einer wärmeleitenden Kappe (27) mit ebener Oberfläche und einem unteren mit einer Ausnehmung mit ebener Deckfläche und einer durchgehenden sich verjüngenden Wand (28) versehenen Unterteil, die im wesentlichen an das besagte abgestumpfte konische Teil (23) angepaßt ist;

einem sich zwischen der Deckfläche und dem besagten darunterbefindlichen konischen Teil (23) angeordneten Element (26), durch das das konische Teil (23) federnd an das Element (20) angepreßt wird;

einer wärmeleitenden Paste (33) zwischen dem konischen Teil (23) und der sich verjüngenden Wand der Ausnehmung sowie

einer dem ebenen oberen Teil der Kappe (27) zugeordneten Wärmesenke.

2. Vorrichtung nach Anspruch 1, wobei zwischen dem Element (20) und der ebenen Grundfläche eine sich anpassende Legierungsschicht (34) vorgesehen ist, und

die Legierung einen niedrigen Schmelzpunkt und hohe Wärmeleitfähigkeit zur Steigerung der Wärmeübertragung zwischen dem besagten Element (20) und dem konischen Teil (23) aufweist.

3. Vorrichtung nach Anspruch 1 oder 2, wobei es sich bei dem besagten Element um ein wärmeerzeugendes integriertes Halbleiterchip (20) handelt;

das konische Teil als wärmeleitende, ebenflächige, abgestumpfte, konische Scheibe (23) ausgebildet ist, und die Grundfläche mit der Rückfläche des Chips (20) verbunden ist;

das Kappenteil als wärmeleitende dickwandige Kappe (27) mit einer im wesentlichen an die abgestumpfte Scheibe (23) angepaßten sich verjüngenden Innenfläche (28) versehen ist;

das Element zum federnden Anpressen des konischen Teils als Feder (26) ausgebildet ist, die sich zwischen der Kappe (27) und der Scheibe (23) befindet, um letztere (23) gegen das Chip (20) unter Ausbildung eines schmalen peripheren Spaltes zwischen dem konischen Teil der Scheibe (23) und der sich verjüngenden Fläche der Kappe (27) anzupressen, und

die wärmeleitende Paste (33) in den peripheren Spalt eingefüllt wird, wodurch ein niedriger thermischer Übergangswiderstand zwischen der Scheibe (23) und der Kappe (27) entsteht.

4. Vorrichtung nach Anspruch 3, wobei der Oberflächenbereich des konische Teils der Scheibe (23) 5 bis 10 größer als der des Chips (20) ist.

5. Vorrichtung nach den Ansprüchen 1 bis 4, wobei eine Ausnehmung (25) in einem zentralen Teil des abgestumpften Endes besagter Scheibe zur Befestigung des unteren Teils der Feder (26) vorgesehen ist.

6. Vorrichtung nach Anspruch 3, wobei die Kappe (27) eine ebene Deckfläche (29) mit einer zentral angeordneten Ausnehmung (31) entsprechend der Ausnehmung (25) in der Scheibe (23) zur Befestigung des oberen Teils der Feder (26) aufweist.

7. Modul zur Kühlung einer Vielzahl wärmeerzeugender, integrierter, mit der Stirnfläche nach unten an einem Substrat (21) befestigter Halbleitchips (20) mit

einer Vielzahl von wärmeleitenden, abgestumpften, massiven, konischen Scheiben (23), deren ebene Grundfläche mit jeweils einem der besagten Chips (20) thermisch verbunden ist;

einer wärmleitenden Modulkappe, deren Kanten mit dem Substrat (21) verbunden sind, und die eine Vielzahl von Chips (20) umschließt, wobei die Kappe mit einer Vielzahl von Ausnehmungen versehen ist, die jeweils einer der besagten Scheiben (23) entsprechen und jeweils einen ebene Deckfläche (29) sowie eine durchgehende sich nach außen verjüngende, an die entsprechende Scheibe (23) angepaßte Wandung (28) aufweisen;

einer Vielzahl von Federn (26), die sich im zusammengepreßten Zustand zwischen jeder Ausnehmungsdeckfläche (29) und der entsprechend abgestumpten Scheibe (23) befinden, wodurch die Scheiben gegen die jeweiligen Chips (20) gepreßt und kleine periphere Spalte zwischen der sich verjüngenden Wand der Ausnehmungen und den entsprechenden Scheiben gebildet werden;

einer wärmeleitenden Paste (33), die in die besagten Spalte eingefüllt wird, sowie

an die Modulkappe angeschlossene Mittel zur Wärmeableitung, die durch die Chips (20) erzeugte Wärme von außen von der Kappe ableiten.

8. Kühlmodul nach Anspruch 7, dadurch gekennzeichnet, daß eine sich anpassende aus einer Legierung bestehende Übergangschict (34) zwischen jedem Chip (20) und der entsprechenden Scheibengrundfläche (23) ausgebildet wird, wobei die Legierung durch die von der Scheibe ausgehende Wäre eine hohe thermische Leitfähigkeit und einen niedrigen Schmelzpunkt aufweist und somit schmelzen und zwischen dem Chip (20) und der Scheibe (23) einen niedrigen thermischen Übergangswiderstand bilden kann.

9. Kühlmodul nach Anspruch 7, wobei die Scheiben (23) und einem aluminium-, kupfer-, silber- und siliciumkarbidhaltigen Material hergestellt werden.

10. Kühlmodul nach Anspruch 7, wobei dasselbe aus einem aluminium-, kupfer-, silber- und siliciumkarbidhaltigen Material hergestellt wird.

**Revendications**

1. Appareil pour le refroidissement par conduction d'un élément engendrant de la chaleur (20), ledit appareil comprenant
un organe conique, plein, tronqué, thermiquement conducteur (23) ayant une base plate en communication thermique avec ledit élément (20) par ladite base;
un couvercle thermiquement conducteur (27) ayant une partie supérieure plate et une partie inférieure ayant une cavité avec un plafond plat en une paroi conique continue (28) pour correspondre sensiblement audit organe conique tronqué (23);
un moyen (26) placé entre ledit plafond et ledit organe conique (23) situé au dessous pour serrer de façon élastique ledit organe conique (23) contre ledit élément (20);
une couche de graisse thermiquement conductrice (33) placée entre ledit organe conique (23) et la paroi conique de ladite cavité; et
des moyens dissipateurs de chaleur associés à ladite partie supérieure plate du couvercle (27).

2. Appareil selon la revendication 1, dans lequel une couche d'alliage autoregénérable (34) est placée entre ledit élément (20) et la base plate, l'alliage ayant un bas point de fusion et une conductivité thermique élevée, afin d'améliorer le transfert de chaleur depuis ledit élément (20) vers ledit organe conique (23).

3. Appareil selon la revendication 1 ou 2, dans lequel ledit élément est une pastille de circuits intégrés à semiconducteurs engendrant de la chaleur (20);
l'organe conique est un disque conique, plein, tronqué et à base plate conducteur de chaleur (23), ladite base contactant la surface arrière de ladite pastille (20);
le couvercle est un chapeau à paroi épaisse, conducteur de chaleur (27), ayant une surface intérieure conique (28) s'adaptant essentiellement audit disque tronqué (23);
le moyen pour serrer de façon élastique l'organe conique est un ressort (26) placé entre ledit chapeau (27) et ledit disque (23) pour pousser le disque (23) contre la pastille (20) et former un espace périphérique étroit entre la partie conique dudit disque (23) et ladite surface conique du chapeau (27);
la couche de graisse thermiquement conductrice (33) remplissant ledit espace périphérique pour fournir une résistance thermique d'interface faible entre le disque (23) et le chapeau (27).

4. Appareil selon la revendication 3, dans lequel la partie conique du disque (23) a une aire de surface d'environ 5 à 10 fois l'aire de ladite pastille (20).

5. Appareil selon les revendications 1 à 4, dans lequel une cavité (25) est placée dans une partie centrale de l'extrémité tronquée dudit disque pour retenir au dedans la partie inférieure dudit ressort (26).

6. Appareil selon la revendication 3, dans lequel ledit chapeau (27) a un plafond plat (29) avec une cavité centrale (31) en correspondance avec la cavité (25) dans ledit disque (23) pour retenir au dedans la partie supérieure dudit ressort (26).

7. Module pour refroidir un ensemble de pastilles de circuits intégrés à semiconducteurs engendrant de la chaleur (20) monté la face en bas sur un substrat (21), ledit module comprenant un ensemble de disques coniques, pleins, tronques, conducteurs de chaleur (23) ayant une base plate, chacun en contact thermique avec une desdites pastilles (20) par ladite base;

un couvercle de module conducteur de chaleur scellé à ses bords audit substrat (21) entourant ledit ensemble de pastilles (20), ledit couvercle comportant un ensemble de cavités, chacune en correspondance avec un desdits disques (23), lesdites cavités ayant chacune un plafond plat (29) et une paroi continue s'évassant vers l'extérieur (28) pour s'adapter audit disque correspondant (23);

un ensemble de ressorts (26) comprimés chacun entre chacun desdits plafonds (29) de cavité et ledit disque tronqué correspondant (23) pour maintenir ledit disque serré contre des pastilles respectives (20) et établir également de petits espaces périphériques entre la paroi conique desdites cavités et les disques correspondants;

une graisse conductrice thermique (33) remplissant lesdits espaces périphériques; et

des moyens d'évacuation de chaleur couplés thermiquement audit couvercle de module pour évacuer vers l'extérieur, depuis le couvercle, la chaleur engendrée par lesdites pastilles (20).

8. Module de refroidissement selon la revendication 7, caractérisé par une interface en alliage autoregénérable (34) formée entre chacune desdites pastilles (20) et la base de disque correspondant (23), ledit alliage ayant une conductivité thermique élevée et un bas point de fusion, en raison de la chaleur dudit disque correspondant, et étant capable de fondre et de fournir une résistance thermique interfaciale faible entre ladite pastille (20) et le disque (23).

9. Module de refroidissement selon la revendication 7, dans lequel lesdits disques (23) sont fabriqués dans une matière sélectionnée parmi le groupe comprenant l'aluminium, le cuivre, l'argent et le carbure de silicium.

10. Module de refroidissement selon la revendication 7, dans lequel ledit couvercle de module est fabriqué dans une matière sélectionnée parmi le groupe comprenant l'aluminium, le cuivre, l'argent et le carbure de silicium.

FIG. 1 (PRIOR ART)

FIG. 2 (PRIOR ART)

FIG. 3

FIG. 4

FIG. 5

FIG. 6